# EUROPÄISCHE PATENTANMELDUNG

(11) **EP 2 258 657 A1**
(43) Veröffentlichungstag der Anmeldung: **08.12.2010**
(21) Anmeldenummer: 10010260.7
(22) Anmeldetag: 18.09.2004
(51) Int. Cl.: B81C 3/00, B01L 3/00, F16L 13/11, B01J 19/00

(54) **Verfahren und Vorrichtung zum Koppeln von Hohlfasern an ein mikrofluidisches Netzwerk**

(30) Priorität: 30.09.2003 DE 10345817
(62) Teilanmeldung aus: 04022269.7
(71) Anmelder: BOEHRINGER INGELHEIM microParts GmbH, 44227 Dortmund (DE)
(72) Erfinder: Yu, Ying, 55216 Ingelheim (DE); Peters, Ralf-Peter, 55216 Ingelheim (DE); Stoeters, Wolfgang, 55216 Ingelheim (DE)
(74) Vertreter: Gesthuysen, von Rohr & Eggert

(57) **Zusammenfassung**

Gegenstand der Erfindung ist ein Verfahren, wobei das mikrofluidische Netzwerk mindestens einen oberseitig offenen Kanal aufweist, in dem die Hohlfaser mit einem Ende eingelegt ist. Betroffen ist dabei ein mikrofluidisches System aus einem mikrofluidischen Netzwerk mit einem Mikrostrukturträger mit mindestens einem Kanal und einer mit einem Ende im Kanal eingelegten, stirnseitig in den Kanal mündenden mikrofluidischen Hohlfaser. Bei diesem ist vorgesehen, dass die Außenabmessungen, insbesondere der Außendurchmesser der Hohlfaser so auf die Innenabmessungen, insbesondere die Breite und die Tiefe, des Kanals abgestimmt ist, dass sich zwischen der Hohlfaser und den Wandungen des Kanals, insbesondere in in den Winkeln verbleibenden Zwickeln, Kapillarkanäle ergeben, dass das Netzwerk mit einer auf dem Mikrostrukturträger fixierten Abdeckfolie oder -platte abgedeckt ist, die den Kanal schließt und vorzugsweise die Hohlfaser vorläufig im Kanal fixiert, und dass die Kapillarkanäle mit einem fluidisch dichtenden Kleber ausgefüllt sind. Im Bereich des Endes der Hohlfaser ist eine Kapillarstoppstruktur gebildet, so dass der Kleber beim Einfüllen vor oder am Ende stehen bleibt und die Hohlfaser nicht verschließen kann.

## Beschreibung

Die Erfindung betrifft zunächst ein Verfahren zum Koppeln mindestens einer Hohlfaser an ein mikrofluidisches Netzwerk mit den Merkmalen des Oberbegriffs von Anspruch 1, Weiter betrifft die Erfindung auch eine Vorrichtung zur Realisierung eines solchen Verfahrens, nämlich ein mikrofluidisches System aus einem mikrofluidischen Netzwerk mit einem Mikrostrukturträger und einer angekoppelten mikrofluidischen Hohlfaser mit den Merkmalen des Oberbegriffs von Anspruchs 8,

In der Mikrosystemtechnik ist es bekannt, Komponenten mit mikrostrukturierten Oberflächen durch Klebung miteinander zu verbinden. Mit solchen Verfahren werden oft nur zwei planparallele Flächen miteinander verklebt. Dabei fließt ein Kleber in einer Ebene. Um die zu verbindenden Komponenten mit einer ausreichenden Positioniergenauigkeit miteinander zu verkleben, müssen sie vor dem eigentlichen Klebevorgang durch eine andere Technik relativ zueinander vorläufig fixiert werden. Das ist dann schwierig, wenn mehrere Teile auf unterschiedlichen Ebenen fluidisch dicht miteinander verklebt werden sollen, insbesondere dann, wenn eine der miteinander zu verklebenden Komponenten vergleichsweise beweglich ist, insbesondere bei einer Hohlfaser.

Für sich ist es im übrigen bekannt, einen im Verarbeitungszustand flüssigen Kleber durch Ausnutzung von Kapillarkräften in eng bemaßte Kanäle, Nuten oder andere Funktionsbereiche fließen zu lassen (vgl. insbesondere Wolfgang Menz; Jürgen Mohr: "Mikrosystemtechnik für Ingenieure", VCH Verlagsgesellschaft mbH, 2. Aufl. 1997, ISBN 3-527-29405-8).

Die DE 34 08 783 C2 betrifft ein Verbindungselement für Lichtwellenleiter, wobei die Lichtwellenleiter in mikrostrukturierte Nuten eingeklebt werden.

Die WO 98/25065 A1, die den Ausgangspunkt der vorliegenden Erfindung bildet, offenbart ein mikrofluidisches Netzwerk, wobei mindestens eine Hohlfaser in einen Kanal eingeklebt wird. Die Hohlfaser wird in den Kanal eingelegt, der Kanal wird durch eine Abdeckplatte abgedeckt, und anschließend wird - bedarfsweise über einen seitlichen Zulauf - ein Klebstoff zugeführt, der bedarfsweise durch UV-Strahlung insbesondere im Bereich des stirnseitigen Endes der Hohlfaser aushärtbar ist und die Hohlfaser im Kanal verklebt. Das bekannte Verfahren stellt jedoch eine optimale Positionierung der Hohlfaser im Kanal nicht sicher. Problematisch ist insbesondere, dass überschießender Klebstoff unerwünschter Weise in das eingeführte, offene Ende der Hohlfaser eindringen und diese verschließen kann.

Die WO 97/29394 A1 betrifft das Einkleben einer optischen Faser in eine V-Nut, wobei Klebstoff über zwei gegenüberliegende, seitliche Zulaufkanäle der V-Nut zugeführt wird, so dass eine vollständige Ummantelung der Faser mit Klebstoff vermieden werden kann.

Die WO 01/86154 A1 offenbart das Einkleben eines Kapillanohrs in einen Kanal, wobei die Innenfläche des Kanals und die Außenfläche des Kapillarrohrs in vorbestimmter Orientierung und Abstand zueinander gehalten werden, um einen gewünschten Kapillareffekt dazwischen zu erreichen, und wobei Klebstoff in einer abgestimmten Menge zugeführt wird, um den Zwischenraum zu füllen. Die Bestimmung und Einhaltung dieser Menge ist jedoch schwierig und ggf. aufwendig. Problematisch ist insbesondere, dass überschießender Klebstoff unerwünschter Weise in das eingeführte, offene Ende der Hohlfaser eindringen und diese verschließen kann.

Die FR 2 813 073 A1 offenbart das Einkleben von Kapillaren in V-förmigen Nuten einer Mikrostruktur, wobei mehrere Kapillare mittels eines Halteelements in die gegenüber einer Abdeckung vorspringenden Nuten eingeführt und bis unter die Abdeckung geschoben werden und anschließend mittels Klebstoff in den Nuten verklebt werden. Problematisch ist insbesondere, dass überschießender Klebstoff unerwünschter Weise in das eingeführte, offene Ende der Hohlfaser eindringen und diese verschließen kann.

Der vorliegenden Erfindung liegt die Aufgabe zugrunde, ein Verfahren zum Koppeln mindestens einer mikrofluidischen Hohlfaser an ein mikrofluidisches Netzwerk und ein damit versehenes mikrofluidisches System anzugeben, wobei ein unerwünschtes Verschließen der Hohlfaser durch Klebstoff an ihrem eingeführten, offenen Ende auf einfache Weise sicher vermieden werden kann und insbesondere eine gewünschte Positionierung und Festlegung der Hohlfaser und/oder ein optimales gleichzeitiges Verkleben und Abdichten mehrerer Teile ermöglicht werden.

Die obige Aufgabe wird durch ein Verfahren gemäß Anspruch 1 oder ein mikrofluidisches Netzwerk gemäß Anspruch 8 gelöst. Vorteilhafte Weiterbildungen sind Gegenstand der Unteransprüche.

Erfindungsgemäß wird durch eine im Bereich des Endes der Hohlfaser im Kanal gebildete Kapillarstoppstruktur erreicht, dass der Kleber beim Einfüllen vor oder am Ende der Hohlfaser stehen bleibt und dementsprechend die Hohlfaser nicht verschließen kann. Die Kapillarstoppstruktur ist sehr einfach und kostengünstig herstellbar und gestattet ein sehr einfaches Einfüllen des Klebers, da insbesondere keine zusätzlichen Vorkehrungen zur Verhinderung eines Verschließens der Hohlfaser durch den Kleber getroffen werden müssen. Vielmehr genügt bei der bevorzugten Ausgestaltung die Kapillarstoppstruktur, um den Klebstoffstrom zum stirnseitigen Ende der Hohlfaser hin zu stoppen. Die erfindungsgemäße Lösung gestattet dementsprechend eine sehr einfache Herstellung der erfindungsgemäßen mikrofluidischen Systeme, da beispielsweise keine besonders abgestimmte Menge an Kleber zugeführt werden muss und da es beispielsweise auch nicht erforderlich ist, den Klebstoff aktiv durch lokales Aushärten o. dgl. vor dem Ende der Hohlfaser zu stoppen.

Eine vorzugsweise vorgesehene, zumindest vorläufige Fixierung der im Kanal eingeführten Hohlfaser durch die Abdeckfolie oder -platte, insbesondere bis zum Einfüllen und Aushärten des Klebers, ermöglicht auf sehr einfache Weise eine sehr genaue Positionierung und Festlegung der Hohlfaser. Dies ist einem definierten Verbinden und Abdichten zuträglich. Des weiteren wird eine einfache und schnelle Herstellung gestattet, da insbesondere keine zusätzlichen Haltemittel o. dgl. zur Positionierung der Hohlfaser im Kanal während des Verklebens erforderlich sind.

Insbesondere wird der Vorteil erreicht, dass eine für das Kleben konstruierte einfache Kanalstruktur, die sich auf dem mikrofluidischen Mikrostrukturträger befindet, gleichzeitig zwei Funktionen erfüllt. Zum einen wird eine an sich bewegliche Hohlfaser vor dem Kleben durch die Struktur so fixiert, dass die Hohlfaser exakt in ihrer Sollposition liegt und sich praktisch nicht mehr bewegt. Zum anderen wird der im Verarbeitungszustand flüssige Kleber durch die Kanalstruktur des Mikrostrukturträgers optimal in den zu klebenden Bereich geführt. Mikrofluidische Baugruppen können somit mit beweglichen Komponenten fluidisch dicht und ohne Verstopfung geklebt werden. Das muss nicht nur in einer Ebene geschehen, sondern kann sich auch über mehrere Koppelpunkte in mehreren Ebenen erstrecken im Sinne eines dreidimensionalen mikrofluidischen Netzwerks.

Mit der Erfindung wird erreicht, dass man mikrofluidische Hohlfasern an ein mikrofluidisches Netzwerk mit mikrostrulcturierten Kanälen auf einem von einer Abdeckfolie oder Abdeckplatte abgedeckten Chip durch Kleben verbinden kann, ohne zusätzliche dichtende Komponenten zu benötigen. Eine Abdeckplatte in diesem Sinne kann auch ein weiterer mikrostrukturierter Chip sein.

Nach weiterer Lehre der Erfindung gewährleisten Kapillarstopstrukturen und/oder Ablaufkanäle eine genaue Dosierung des Klebers im Verarbeitungszustand, so dass die Hohlfaser oder Hohlfasern im Kanal oder den Kanälen flüssigkeitsdicht geklebt sind, wobei aber der Kanal im Inneren der Hohlfaser von jedem Klebstoffeintritt frei bleibt.

Besonders bevorzugt ist dieses System aufgrund der Tatsache, dass das Verfahren in der Produktion eingesetzt werden kann, da die unvermeidlichen Schwankungen im Dosierungssystem des Klebers durch die Kanalstruktur im Mikrostrukturträger von selbst kompensiert werden.

In verfahrenstechnischer Hinsicht gilt zunächst, dass der im Verarbeitungszustand flüssige Kleber die zwischen Hohlfaser und Kanalwandungen verbleibenden Kapillarkanäle unter Nutzung der Kapillarkräfte, die dort auftreten, ausfüllt. Danach wird der Kleber in den Endzustand gebracht, insbesondere ausgehärtet. Auch durch Temperaturerhöhung kann eine Aushärtung erfolgen. Es hängt vom Material des Klebers ab, wie der Endzustand erreicht wird.

Für eine optimale Funktionsweise des erfindungsgemäßen Verfahrens ist es besonders zweckmäßig, wenn die Kapillarität der Kapillarkanäle größer ist als die Kapillarität des Zulaufkanals und/oder des Ablaufkanals. Dadurch ist sichergestellt, dass der flüssige Kleber in der gewünschten Weise zwischen Hohlfaser und Kanalwandungen eintritt. Hinsichtlich der quantitativen Bemessung der Kapillaritäten kommt es auf die Kanalquerschnitte, die Viskosität des Klebers, die Benetzungsfähigkeit des Klebers auf der spezifischen Oberfläche etc. an, Das wird im einzelnen vom Fachmann für den jeweiligen Anwendungsfall ermittelt.

Überdies muss festgestellt werden, dass die Kanäle, in denen die Hohlfasern einliegen, am anderen Ende zur Umgebungsatmosphäre offen sind, um ein Einlaufen des Klebers in die Kapillarkanäle zu ermöglichen. Das ist jedenfalls bevorzugt, wenn man nicht mit gezielten Druckerhöhungen oder gezieltem Unterdruck arbeiten will.

Interessant ist, dass man mit dem erfindungsgemäßen System mittels eines Ablaufkanals überschüssigen Kleber im Verarbeitungszustand aus dem Kanal ableiten kann.

Zusätzlich zur Kapiliarstopstruktur kann auch eine Maske mit einem Schlitz an der richtigen Stelle, an der der Kleber im Kapillarkanal stehen bleiben soll, vorgesehen werden. Beispielsweise durchtritt hier UV-Strahlung eine Abdeckfolie, die ansonsten für UV-Strahlung nicht durchlässig ist. Der Kleber, der die Durchlassstelle erreicht, härtet hier aus und kann demzufolge nicht weiter fließen.

Alternativ oder zusätzlich wird das Fliessen des Klebers in den Kapillarkanälen beobachtet und ggf, gezielt das Aushärten des Klebers eingeleitet.

Man kann für die Hohlfaser Polymermaterial einsetzen, es sind aber auch Metallkapillaren, Glaskapillaren sowie Kapillaren aus Keramik oder Cellulose bekannt, die die Funktion einer solchen Hohlfaser erfüllen können. Hohlfasern dieser Art sind auch und insbesondere Dialysefasem wie sie in Dialysegeräten eingesetzt werden.

In verfahrenstechnischer Hinsicht von besonderer Bedeutung ist, dass nach bevorzugter Lehre der Erfindung der Kleber drucklos, d. h. nur unter der Wirkung des Eigendruckes des Klebervorrats in den Kanal eingeleitet wird, Insbesondere die Kapillarkräfte in den Kapillarkanälen sind also für das "Einziehen" des Klebers verantwortlich. Das stellt sicher, dass die Kapillarstopstrukturen im Mikrostrukturträger ihre Wirkung sicher entfalten, so dass der im Inneren der Hohlfaser gebildete Längskanal nicht blockiert wird.

Grundsätzlich ist es möglich, in einem Kanal eine Hohlfaser anzuordnen. Ggf. ist es aber auch zweckmäßig, in einem Kanal mehr als eine Hohlfaser, insbesondere zwei Hohlfasern anzuordnen, die gleichzeitig mit dem Kleber verklebt werden. Grundsätzlich ist es auch möglich, zwei Hohlfasern, die ineinander geschoben sind, mit einer solchen Kapillarklebetechnik zu verbinden.

Im Normalfall wird man in einem Mikrostrukturträger des mikrofluidischen Netzwerks eine Vielzahl von Kanälen haben, die eine Vielzahl von Hohlfasern endseitig aufnehmen. Dafür bietet nun Aspekt 16 eine besonders bevorzugte verfahrenstechnische Lösung, die eine Kopplung der Kanäle erlaubt. Das kann man gruppenweise vorsehen, was eine bevorzugte Lösung sein wird.

Hinsichtlich des bereits oben angesprochenen mikrofluidischen Systems wird nun anschließend mit Bezug auf die Zeichnung eine Erläuterung bevorzugter Ausfühnrngsbeispiele angeschlossen. In der Zeichnung zeigt
Fig. 1 in einer perspektivischen, dreidimensional anmutenden Darstellung das Grundprinzip eines erfindungsgemäßen mikrofluidischen Systems,
Fig. 2 das mikrofluidische System aus Fig. 1 in einer Draufsicht.

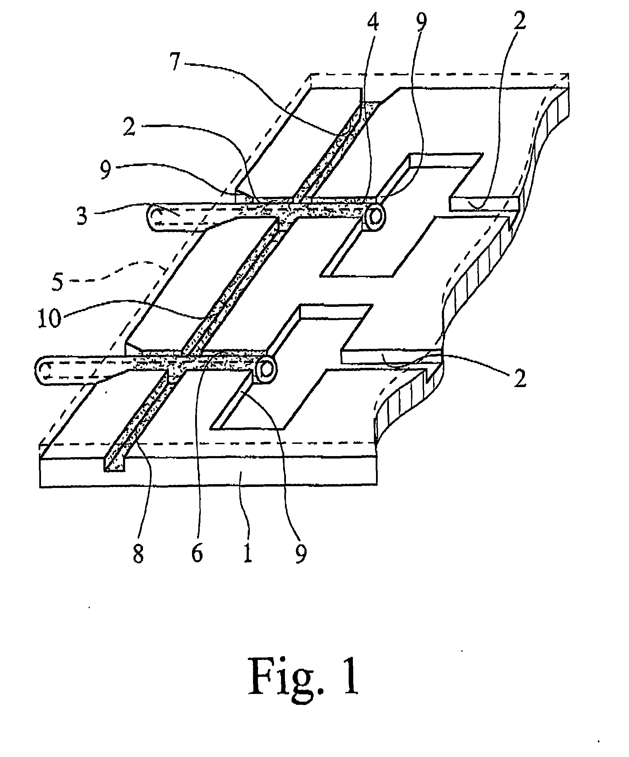

Das in Fig. 1 dargestellte mikrofluidische System aus einem mikrofluidischen Netzwerk mit einem Mikrostrukturträger 1 mit mindestens einem Kanal 2 und einer mit einem Ende im Kanal 2 eingelegten, stirnseitig in den Kanal 2 mündenden mikrofluidischen Hohlfaser 3, ist **dadurch gekennzeichnet, dass** die Außenabmessungen, insbesondere der Außendurchmesser, der Hohlfaser 3 so auf die Innenabmessungen, insbesondere die Breite und die Tiefe, des Kanals 2 abgestimmt sind, dass sich zwischen der Hohlfaser 3 und den Wandungen des Kanals 2, insbesondere in in den Winkeln verbleibenden Zwickeln, Kapillarkanäle 4 ergeben, dass das Netzwerk mit einer auf dem Mikrostrukturträger 1 fixierten Abdeckfolie oder -platte 5 abgedeckt ist, die den Kanal 2 schließt, und dass die Kapillarkanäle 4 von einem fluidisch dichtenden Kleber 6 ausgefüllt sind. Fig. 1 lässt nur gestrichelt angedeutet und maßlich nicht maßstabgerecht die Abdeckfolie 5 erkennen, bei der es sich hier um eine Heißsiegelfolie aus einem Polymerkunststoff handelt, der für UV-Strahlung durchlässig ist. Es kann sich aber auch um eine plattenartige Abdeckung, z.B. aus Glas, handeln. Eine solche kann selbst auch wiederum ein Chip sein.

Besonders bevorzugt ist, dass der Kleber 6 seitlich in den Kanal 2 eingeführt wird. Dazu ist im dargestellten Ausführungsbeispiel vorgesehen, dass mindestens ein dort, wo die Hohlfaser 3 eingelegt ist, seitlich in den Kanal 2 mündender Zulaufkanal 7 vorgesehen ist, dessen anderes Ende eine Eintrittsstelle für einen im Verarbeitungszustand flüssigen Kleber 6 bildet. Der Zulaufkanal 7 befindet sich hier lateral seitlich des Kanals 2. Im Grundsatz könnte er auch orthogonal von unten her durch den Mikrostrukturträger 1, also beispielsweise einen Siliziumchip, in den Kanal 2 münden. Es geht dabei um die Zufuhr des Klebers 6 in den Zulaufkanal 7, die auf irgendeine Weise bewerkstelligt werden muss, beispielsweise durch eine Öffnung in der Abdeckfolie 5. Zu erwähnen ist hier, dass mehrere Anschlüsse auch in mehreren Ebenen liegen können im Sinne eines dreidimensionalen mikrofluidischen Netzwerkes wie oben bereits erwähnt.

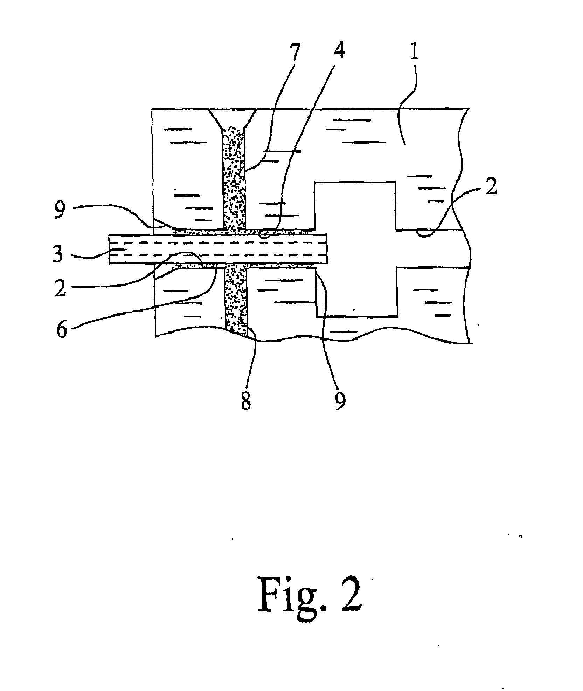

Fig. 1 und 2 zeigen weiter, dass mindestens ein dort, wo die Hohlfaser 3 eingelegt ist, seitlich vom Kanal 2 abgehender Ablaufkanal 8 vorgesehen ist, durch den überschüssiger Kleber 6 ablaufen kann. Man kann also unter Eigendruck des Klebers 6 diesen mit Überschuss dosieren und es ist sichergestellt, dass der Ablaufkanal 8 überschüssigen Kleber 6 abführt, so dass der Kleber 6 den Innenkanal in der Hohlfaser 3 nicht erreicht und blockiert.

Damit sich für die Hohlfaser 3 keine Blockierung deren Innenkanals ergibt, ist im dargestellten und insoweit bevorzugten Ausführungsbeispiel vorgesehen, dass etwa dort, wo die Hohlfaser 3 aus dem Kanal 2 nach außen austritt, und/oder etwa dort, wo sich im Kanal 2 das Ende der Hohlfaser 3 befindet, im Kanal 2 jedenfalls die Wandabschnitte mit einer den Kanal 2 verbreiternden, stufenartigen oder schräg verlaufenden Kapillarstopstruktur 9 ausgeführt sind. Man erkennt dazu in Fig. 2 in der Draufsicht, dass die Kapillarstoppstruktur 9 am äußeren Ende des Kanals 2 eine trapezartige Erweiterung bildet Ferner erkennt man in Fig. 2, dass im hier dargestellten Ausführungsbeispiel die Kapillarstopstruktur 9 am inneren Ende eine beidseitige Stufe bildet.

In beiden zuvor erläuterten Fällen, also an beiden Enden des Kanals 2, kann man davon ausgehen, dass die Modifikation durch die Kapillarstopstrukturen 9 auch an der Unterseite, also im Mikrostrukturträger 1, vorgesehen ist. Nicht vorgesehen dürfte diese Struktur sein an der Oberseite, weil dort mittels der Abdeckfolie 5, die solche Strukturen nicht erlaubt, der Mikrostrukturträger 1 des mikrofluidischen Netzwerkes glatt abgedeckt ist.

Im Grundsatz bildet auch bereits das Ende der Hohlfaser 3 selbst einen Absatz, der eine Kapillarstopstruktur 9 darstellt. Diese ist aber mitunter nicht so verlässlich wirksam wie eine zusätzliche Kapillarstopstruktur 9. Gleichwohl ist auch dieser einfache Absatz geeignet, wenn man aus Gründen der räumlichen Anordnung größere Abmessungen der Kapillarstopstrukturen 9 wie in der Zeichnung gezeigt, nicht einsetzen kann.

Die wannenartigen Kapillarstopstrukturen 9 in der Zeichnung können kleiner ausgeführt werden, also einen geringeren Inhalt haben, wenn man den Winkel am Ende der Hohlfaser 3 über 90° hinaus wählt, also rücklaufen "ohrenartige" Kapillarstoptrukturen 9 verwirklicht. Dann ist noch sicherer gewährleistet, dass sich keine Blockierung des Innenkanals der Hohlfaser 3 durch Kleber ergibt.

Im Extremfall kann man auch kurz vor dem Ende der Hohlfaser 3 an den seitlichen Kapillarkanälen 4 eigene kanalartige Kapillarstrukturen vorsehen, die gewissermaßen als "Saugkanäle" vor dem Ende der Hohlfaser 3 wirken und überschüssigen Kleber 6 in entsprechende Sammelräume abführen.

Eine alternative Kapillarstopstruktur 9 bildet eine Erweiterung oder Durchlassstelle in einer als Maske ausgeführten Folie oder Platte auf dem mikrofluidischen Netzwerk an der Stelle, an der der Kleber 6 in den Kapillarkanälen 4 um die Hohlfaser 3 stehen bleiben soll.

Zusätzlich kann die bereits im allgemeinen Teil der Beschreibung erläuterte Beobachtung des Einleitens des Klebers 6 erfolgen, um den Kleber 6 dann bedarfsgerecht anzuhalten und/oder in den Endzustand zu überführen.

Um ein Gefühl für die Abmessungen zu haben, um die es hier geht, gibt die Lehre den Hinweis, dass der Kanal 2 mit einer Breite und Tiefe von etwa 30 µm bis etwa 500 µm, vorzugsweise von etwa 100 µm bis etwa 300 µm, ausgeführt wird und dass die Hohlfaser 3 mit darauf abgestimmten Abmessungen, insbesondere einem darauf abgestimmten Durchmesser von etwa 30µm bis etwa 500 µm, vorzugsweise von etwa 100 µm bis etwa 300 µm, ausgeführt ist. Der Innendurchmesser des Innenkanals in der Hohlfaser 3 dürfte dabei zwischen 5 µm und 450 µm, vorzugsweise zwischen etwa 50 µm und etwa 250 µm, betragen.

Als Fluid, das im Inneren der Hohlfaser 3 transportiert wird, kommt in erster Linie eine Flüssigkeit, beispielsweise eine bei der Dialyse relevante Flüssigkeit, in Frage. Grundsätzlich kommt aber auch ein Gas in Frage. Eine Dialysefaser als Hohlfaser 3 hat im Übrigen einen halbdurchlässigen Mantel, der den Medienaustausch im Dialysegerät oder in einer messtechnischen Struktur erlaubt.

Bevorzugte Varianten des Materials für die Hohlfaser sind Polymermaterial, ein Metall, beispielsweise Edelstahl, Glas oder auch Keramik oder Cellulose.

Bereits oben ist darauf hingewiesen worden, dass man als Kleber 6 insbesondere einen unter UV-Strahlung aushärtenden Kleber verwenden kann, der genau gesteuert seinen Aushärtungsprozess beginnt und beendet. Wenn man einen solchen Kleber 6 verwendet, so sollte man die Abdeckfolie 5 oder Abdeckplatte aus einem für UV-Strahlung durchlässigen Material ausführen, Für den Kleber 6 kommen z. B. Acrylate, Urethane, aber auch Zweikomponenten-Epoxydharze in Frage. Die Abdeckfolie 5 kann z. B. aus Polycarbonat, Polyester, Polystyrol oder PVC bestehen bzw. auf dieser Grundlage hergestellt sein.

Bereits oben ist im Übrigen erläutert worden, dass der Kleber 6 im Verarbeitungszustand eine Viskosität von etwa 100 mPas bis etwa 400 mPas aufweisen sollte.

Nicht dargestellt in der Zeichnung ist eine Variante, für die gilt, dass der Kanal 2 mit einer Breite ausgeführt wird, die etwa dem Doppelten der Tiefe entspricht und es ermöglicht, zwei Hohlfasern 3 gleichzeitig in einem Kanal 2 zu verkleben. Entsprechendes kann auch für eine dreikanalige Ausführung o.dgl. gelten.

Fig. 1 zeigt insoweit eine bevorzugte Ausführungsform der Erfindung als mehrere Kanäle 2 des Netzwerkes, in die Hohlfasern 3 eingelegt werden, durch mindestens einen Verbindungskanal 10 für den Kleber 6 miteinander verbunden sind, der die Funktion des Ablaufkanals für einen Kanal 2 und die Funktion des Zulaufkanals für den anderen Kanal 2 erfüllt. Man kann sich anhand von Fig. 3 gut vorstellen, wie dieses mikrofluidische System zum Einleiten des Klebers 6 in das Netzwerk bei im wesentlichen vertikaler Ausrichtung von oben ausgehend, nämlich vom Eintritt des Zulaufkanals 7 her befüllt wird. Damit ergibt sich von selbst der Austritt des flüssigen Klebers 6 aus dem Ablaufkanal 8 am unteren Ende des mikrofluidischen Netzwerks. Durch Kapillarkräfte erfolgt die Seitenverteilung in die Kanäle 2 mit den Hohlfasern 3 so weit, bis die Kapillarstopstrukturen 9 stoppen.

Zum Aushärten wird die gesamte Anordnung in die horizontale Ausrichtung gebracht und dann mit UV-Strahlung bestrahlt.

Weitere Aspekte der vorliegenden Erfindung sind:
1. Verfahren zum Koppeln mindestens einer mikrofluidischen Hohlfaser an ein mikrofluidisches Netzwerk,
   wobei das mikrofluidische Netzwerk mindestens einen oberseitig offenen Kanal (2) aufweist, in dem die Hohlfaser (3) mit einem Ende eingelegt wird, und:
   a) die Außenabmessungen, insbesondere der Außendurchmesser, der Hohlfaser (3) so auf die Innenabmessungen, insbesondere die Breite und die Tiefe des Kanals (2) abgestimmt werden, dass sich zwischen der Hohlfaser (3) und den Kanalwandungen, insbesondere in in den Winkeln verbleibenden Zwickeln, Kapillarkanäle (4) ergeben;
   b) das mikrofluidische Netzwerk bei im Kanal (2) einliegender Hohlfaser (3) mit einer Abdeckfolie oder -platte (5) abgedeckt wird, die auf dem Netzwerk fixiert wird und den Kanal (2) oberseitig schließt;
   c) durch mindestens einen in den Kanal (2) mündenden Zulaufkanal (7) im mikrofluidischen Netzwerk wird ein im Endzustand fluidisch dichtender, im Verarbeitungszustand flüssiger Kleber (6) in den Kanal (2) dort eingeleitet, wo die Hohlfaser (3) einliegt, so dass sich die Kapillarkanäle (4) um die Hohlfaser (3) herum füllen;
   d) nach Abschluss des Verfahrensschrittes d) wird der Kleber (6) in den Endzustand gebracht, insbesondere ausgehärtet, bzw. erreicht diesen;
   **dadurch gekennzeichnet,**
   **dass** der noch flüssige Kleber (6) im Kanal (2) im Bereich des Endes der Hohlfaser (3) durch eine Kapillarstoppstruktur (9) gestoppt wird.
2. Verfahren nach Aspekt 1, **dadurch gekennzeichnet, dass** durch mindestens einen vom Kanal (2) abgehenden Ablaufkanal (8) im mikrofluidischen Netzwerk überschüssiger Kleber (6) im Verarbeitungszustand aus dem Kanal (2) abgeleitet wird und/oder dass im Verfahrensschritt b) die Abdeckfolie oder - platte (5) die Hohlfaser (3) im Kanal (2) vorläufig fixiert.
3. Verfahren nach Aspekt 1 oder 2, **dadurch gekennzeichnet, dass** die Kapillarstoppstruktur (9) durch den Kanal (2) vorzugsweise stufenartig verbreiternde Wandabschnitte und/oder einen insbesondere stirnseitigen Absatz der Hohlfaserwandung gebildet wird.
4. Verfahren nach einem der vorhergehenden Aspekte, **dadurch gekennzeichnet, dass** die Abdeckfolie oder -platte (5) oder eine zusätzliche Folie oder Platte auf dem mikrofluidischen Netzwerk als Maske mit einer Durchlassstelle an der Stelle, an der der Kleber (6) in den Kapillarkanälen (4) um die Hohlfaser (3) stehen bleiben soll, ausgeführt ist und dass während des Einleitens des Klebers (6) an der Durchlassstelle eine solche Beeinflussung des Klebers (6) erfolgt, dass dieser hier seinen Endzustand erreicht.
5. Verfahren nach einem der vorhergehenden Aspekte, **dadurch gekennzeichnet, dass** etwa dort, wo die Hohlfaser (3) aus dem Kanal (2) nach außen austritt, im Kanal (2) jedenfalls die Wandabschnitte mit einer den Kanal (2) verbreiternden, vorzugsweise stufenartigen oder schräg verlaufenden Kapillarstoppstruktur (9) versehen sind.
6. Verfahren nach einem der vorhergehenden Aspekte, **dadurch gekennzeichnet, dass** während des Einleitens des Klebers (6) in die Kapillarkanäle (4) um die Hohlfaser (3) das Fliessen des Klebers (6) erfasst, insbesondere beobachtet wird und dann, wenn der Kleber (6) eine Stelle erreicht, an der er stehen bleiben soll, der Kleber (6) in den Endzustand gebracht wird.
7. Verfahren nach einem der vorhergehenden Aspekte, **dadurch gekennzeichnet, dass** der Kanal (2) mit einer Breite und Tiefe von etwa 30 µm bis etwa 500 µm, vorzugsweise etwa 100 µm bis etwa 300 µm, ausgeführt wird und dass die Hohlfaser (3) mit darauf abgestimmten Abmessungen, insbesondere einem darauf abgestimmten Durchmesser, von etwa 30 µm bis etwa 500 µm, vorzugsweise etwa 100 µm bis etwa 300 µm, ausgeführt wird.
8. Verfahren nach einem der vorhergehenden Aspekte, **dadurch gekennzeichnet, dass** als Hohlfaser (3) eine Faser aus Polymermaterial, aus Metall, aus Glas, aus Keramik oder aus Cellulose verwendet wird und/oder dass als Hohlfaser (3) eine Dialysefaser verwendet wird.
9. Verfahren nach einem der vorhergehenden Aspekte, **dadurch gekennzeichnet, dass** als Kleber (6) ein flüssiger Klebstoff mit einer Viskosität von etwa 10 mPas bis etwa 600 mPas, vorzugsweise von etwa 100 mPas bis etwa 400 mPas, verwendet wird.
10. Verfahren nach einem der vorhergehenden Aspekte, **dadurch gekennzeichnet, dass** als Kleber (6) ein unter UV-Strahlung aushärtender Klebstoff verwendet und der Kleber (6) durch Bestrahlen mit UV-Strahlung in den Endzustand gebracht wird.
11. Verfahren nach einem der vorhergehenden Aspekte, **dadurch gekennzeichnet, dass** für die Abdeckfolie oder -platte (5) ein für UV-Strahlung durchlässiges Material verwendet wird.
12. Verfahren nach einem der vorhergehenden Aspekte, **dadurch gekennzeichnet, dass** der Kleber (6) quasi drucklos, also im Wesentlichen nur unter Eigendruck des Klebervorrats, in den Kanal (2) eingeleitet wird.
13. Verfahren nach einem der vorhergehenden Aspekte, **dadurch gekennzeichnet, dass** das Einleiten des Klebers (6) in das Netzwerk bei im wesentlichen vertikaler Ausrichtung des Netzwerkes von oben aus erfolgt.
14. Verfahren nach einem der vorhergehenden Aspekte, **dadurch gekennzeichnet, dass** das Fixieren des Klebers (6), insbesondere das Aushärten des Klebers (6), bei im wesentlichen horizontaler Ausrichtung des Netzwerkes erfolgt.
15. Verfahren nach einem der vorhergehenden Aspekte, **dadurch gekennzeichnet, dass** der Kanal (2) mit einer Breite ausgeführt wird, die etwa dem Doppelten der Tiefe entspricht und es ermöglicht, zwei Hohlfasern (3) gleichzeitig in einem Kanal (2) zu verkleben.
16. Verfahren nach einem der vorhergehenden Aspekte, **dadurch gekennzeichnet, dass** mehrere Kanäle (2) des Netzwerkes, in die Hohlfasern (3) eingelegt werden, durch mindestens einen Verbindungskanal (10) für den Kleber (6) miteinander verbunden werden, der die Funktion des Ablaufkanals (8) für einen Kanal (2) und die Funktion des Zulaufkanals (7) für den anderen Kanal (2) erfüllt.
17. Mikrofluidisches System aus einem mikrofluidischen Netzwerk mit einem Mikrostrukturträger (1) mit mindestens einem Kanal (2) und einer mit einem Ende im Kanal (2) eingelegten, stirnseitig in den Kanal (2) mündenden mikrofluidischen Hohlfaser (3),
   wobei die Außenabmessungen, insbesondere der Außendurchmesser der Hohlfaser (3), so auf die Innenabmessungen, insbesondere die Breite und die Tiefe des Kanals (2), abgestimmt sind, dass zwischen der Hohlfaser (3) und den Wandungen des Kanals (2), insbesondere in in den Winkeln verbleibenden Zwickeln, Kapillarkanäle (4) vorliegen,
   insbesondere wobei das Netzwerk mit einer auf dem Mikrostrukturträger (1) fixierten Abdeckfolie oder -platte (5) abgedeckt ist, die den Kanal (2) schließt, und
   wobei die Kapillarkanäle (4) mit einem fluidisch dichtenden Kleber (6) ausgefüllt sind,
   **dadurch gekennzeichnet,**
   **dass** im Bereich des Endes der Hohlfaser (3) im Kanal (2) eine Kapillarstoppstruktur (9) vorgesehen ist, um ein Eindringen des Klebers (6) im flüssigen Zustand endseitig in die Hohlfaser (3) zu verhindern.
18. Mikrofluidisches System nach Aspekt 17, **dadurch gekennzeichnet, dass** die Abdeckfolie oder -platte (5) die Hohlfaser (3) im Kanal (2) vorläufig bis zum Einfüllen und Aushärten des Klebers (6) fixiert.
19. Mikrofluidisches System nach Aspekt 17 oder 18, **dadurch gekennzeichnet, dass** die Kapillarstoppstruktur (9) durch den Kanal (2) vorzugsweise stufenartig verbreiternde Wandabschnitte und/oder einen insbesondere stirnseitigen Absatz der Hohlfaserwandung gebildet ist.
20. Mikrofluidisches System nach einem der Aspekte 17 bis 19, **dadurch gekennzeichnet, dass** die Kapillarstoppstruktur (9) am inneren Ende eine beidseitige Stufe bildet.
21. Mikrofluidisches System nach einem der Aspekte 17 bis 20, **dadurch gekennzeichnet, dass** etwa dort, wo die Hohlfaser (3) aus dem Kanal (2) nach außen austritt, im Kanal (2) jedenfalls die Wandabschnitte mit einer den Kanal (2) verbreiternden, vorzugsweise stufenartigen oder schräg verlaufenden, äußeren Kapillarstoppstruktur (9) ausgeführt sind.
22. Mikrofluidisches System nach Aspekte 21, **dadurch gekennzeichnet, dass** die äußere Kapillarstoppstruktur (9) am äußeren Ende des Kanals (2) eine trapezartige Erweiterung bildet.
23. Mikrofluidisches System nach einem der Aspekte 17 bis 22, **dadurch gekennzeichnet, dass** die Abdeckfolie oder -platte (5) oder eine zusätzliche Folie oder Platte auf dem mikrofluidischen Netzwerk als Maske mit einer Durchlassstelle oder Erweiterung an der Stelle, an der der Kleber (6) in den Kapillarkanälen (4) um die Hohlfaser (3) stehen bleiben soll, ausgeführt ist.
24. Mikrofluidisches System nach einem der Aspekte 17 bis 23, **dadurch gekennzeichnet, dass** mindestens ein dort, wo die Hohlfaser (3) eingelegt ist, seitlich in den Kanal (2) mündender Zulaufkanal (7) vorgesehen ist, dessen anderes Ende eine Eintrittsstelle für den im Verarbeitungszustand flüssigen Kleber (6) bildet.
25. Mikrofluidisches System nach einem der Aspekte 17 bis 24, **dadurch gekennzeichnet, das**s mindestens ein dort, wo die Hohlfaser (3) eingelegt ist, seitlich vom Kanal (2) abgehender Ablaufkanal (8) vorgesehen ist, durch den überschüssiger Kleber (6) ablaufen kann.
26. Mikrofluidisches System nach einem der Aspekte 17 bis 25, **dadurch gekennzeichnet, dass** der Kanal (2) mit einer Breite und Tiefe von etwa 30 µm bis etwa 500 µm, vorzugsweise etwa 100 µm bis etwa 300 µm, ausgeführt ist und dass die Hohlfaser (3) mit darauf abgestimmten Abmessungen, insbesondere einem darauf abgestimmten Durchmesser, von etwa 30 µm bis etwa 500 µm, vorzugsweise etwa 100 µm bis etwa 300 µm, ausgeführt ist.
27. Mikrofluidisches System nach einem der vorgehenden Vorrichtungsaspekte, **dadurch gekennzeichnet, dass** die Hohlfaser (3) eine Faser aus Polymermaterial, Metall, Glas, Keramik oder Cellulose ist und/oder dass die Hohlfaser (3) eine Dialysefaser ist.
28. Mikrofluidisches System nach einem der Aspekte 17 bis 27, **dadurch gekennzeichnet, dass** der Kleber (6) ein Klebstoff ist, der im flüssigen Verarbeitungszustand eine Viskosität von etwa 10 mPas bis etwa 600 mPas, vorzugsweise von etwa 100 mPas bis etwa 400 mPas, aufweist.
29. Mikrofluidisches System nach einem der Aspekte 17 bis 28, **dadurch gekennzeichnet, dass** der Kleber (6) ein unter UV-Strahlung ausgehärteter Kleber ist.
30. Mikrofluidisches System nach einem der Aspekte 17 bis 29, **dadurch gekennzeichnet, dass** die Abdeckfolie oder -platte (5) aus einem für Ultraviolett-Strahlung durchlässigen Material besteht, insbesondere wobei die Abdeckfolie (5) eine Heißsiegelfolie ist.
31. Mikrofluidisches System nach einem der Aspekte 17 bis 30, **dadurch gekennzeichnet, dass** der Kanal (2) mit einer Breite ausgeführt ist, die etwa dem Doppelten der Tiefe des Kanals (2) entspricht, und dass zwei Hohlfasern (3) gleichzeitig in einem Kanal (2) verklebt sind.
32. Mikrofluidisches System nach einem der Aspekte 17 bis 31, **dadurch gekennzeichnet, dass** mehrere Kanäle (2) des Netzwerks, in die Hohlfasern (3) eingelegt sind, durch mindestens einen Verbindungskanal (10) für den Kleber (6) miteinander verbunden sind, der die Funktion des Ablaufkanals für einen Kanal (2) und die Funktion des Zulaufkanals für den anderen Kanal (2) erfüllt.
33. Mikrofluidisches System nach einem der Aspekte 17 bis 32, **dadurch gekennzeichnet, dass** der Zulaufkanal (7) und/oder der Ablaufkanal (8) in einem rechten Winkel auf den Kanal (2) stößt bzw. stoßen.

## Patentansprüche

1. Verfahren zum Koppeln mindestens einer mikrofluidischen Hohlfaser an ein mikrofluidisches Netzwerk,
wobei das mikrofluidische Netzwerk mindestens einen oberseitig offenen Kanal (2) aufweist, in dem die Hohlfaser (3) mit einem Ende eingelegt wird, und:
a) die Außenabmessungen, insbesondere der Außendurchmesser, der Hohlfaser (3) so auf die Innenabmessungen, insbesondere die Breite und die Tiefe des Kanals (2) abgestimmt werden, dass sich zwischen der Hohlfaser (3) und den Kanalwandungen, insbesondere in in den Winkeln verbleibenden Zwickeln, Kapillarkanäle (4) ergeben;
b) das mikrofluidische Netzwerk bei im Kanal (2) einliegender Hohlfaser (3) mit einer Abdeckfolie oder -platte (5) abgedeckt wird, die auf dem Netzwerk fixiert wird und den Kanal (2) oberseitig schließt;
c) durch mindestens einen in den Kanal (2) mündenden Zulaufkanal (7) im mikrofluidischen Netzwerk wird ein im Endzustand fluidisch dichtender, im Verarbeitungszustand flüssiger Kleber (6) in den Kanal (2) dort eingeleitet, wo die Hohlfaser (3) einliegt, so dass sich die Kapillarkanäle (4) um die Hohlfaser (3) herum füllen;
d) nach Abschluss des Verfahrensschrittes d) wird der Kleber (6) in den Endzustand gebracht, insbesondere ausgehärtet, bzw. erreicht diesen;
**dadurch gekennzeichnet,**
**dass** der noch flüssige Kleber (6) im Kanal (2) im Bereich des Endes der Hohlfaser (3) durch eine Kapillarstopstruktur (9) gestoppt wird, wobei etwa dort, wo die Hohlfaser (3) aus dem Kanal (2) nach außen austritt, im Kanal (2) jedenfalls die Wandabschnitte mit einer den Kanal (2) verbreiternden, vorzugsweise stufenartigen oder schräg verlaufenden Kapillarstoppstruktur (9) versehen sind.

2. Verfahren nach Anspruch 1, **dadurch gekennzeiehnet, dass** durch mindestens einen vom Kanal (2) abgehenden Ablaufkanal (8) im mikrofluidischen Netzwerk überschüssiger Kleber (6) im Verarbeitungszustand aus dem Kanal (2) abgeleitet wird.

3. Verfahren nach Anspruch 1 oder 2, **dadurch gekennzeichnet, dass** die Kapillarstoppstruktur (9) durch den Kanal (2) vorzugsweise stufenartig verbreiternde Wandabschnitte und/oder einen insbesondere stirnseitigen Absatz der Hohlfaserwandung gebildet wird.

4. Verfahren nach einem der vorhergehenden Ansprüche, **dadurch gekennzeichnet, dass** im Verfahrensschritt b) die Abdeckfolie oder platte (5) die Hohlfaser (3) im Kanal (2) vorläufig fixiert.

5. Verfahren nach einem der vorhergehenden Ansprüche, **dadurch gekennzeichnet, dass** als Hohlfaser (3) eine Faser aus Polymermaterial, aus Metall, aus Glas, aus Keramik oder aus Cellulose verwendet wird und/oder dass als Hohlfaser (3) eine Dialysefaser verwendet wird.

6. Verfahren nach einem der vorhergehenden Ansprüche, **dadurch gekennzeichnet, dass** als Kleber (6) ein flüssiger Klebstoff mit einer Viskosität von etwa 10 mPas bis etwa 600 mPas, vorzugsweise von etwa 100 mPas bis etwa 400 mPas, verwendet wird.

7. Verfahren nach einem der vorhergehenden Ansprüche, **dadurch gekennzeichnet, dass** mehrere Kanäle (2) des Netzwerkes, in die Hohlfasern (3) eingelegt werden, durch mindestens einen Verbindungskanal (10) für den Kleber (6) miteinander verbunden werden, der die Funktion des Ablaufkanals (8) für einen Kanal (2) und die Funktion des Zulaufkanals (7) für den anderen Kanal (2) erfüllt.

8. Mikrofluidisches System aus einem mikrofluidischen Netzwerk mit einem Mikrostrukturträger (1) mit mindestens einem Kanal (2) und einer mit einem Ende im Kanal (2) eingelegten, stirnseitig in den Kanal (2) mündenden mikrofluidischen klohlfaser (3),
wobei die Außenabmessungen, insbesondere der Außendurchmesser der Hohlfaser (3), so auf die Innenabmessungen, insbesondere die Breite und die Tiefe des Kanals (2), abgestimmt sind, dass zwischen der Hohlfaser (3) und den Wandungen des Kanals (2), insbesondere in in den Winkeln verbleibenden Zwickeln, Kapillarkanäle (4) vorliegen,
insbesondere wobei das Netzwerk mit einer auf dem Mikrostrukturträger (1) fixierten Abdeckfolie oder -platte (5) abgedeckt ist, die den Kanal (2) schließt, und
wobei die Kapillarkanäle (4) mit einem fluidisch dichtenden Kleber (6) ausgefüllt sind,
**dadurch gekennzeichnet,**
**dass** im Bereich des Endes der Hohlfaser (3) im Kanal (2) eine Kapillarstopstruktur (9) vorgesehen ist, um ein Eindringen des Klebers (6) im flüssigen Zustand endseitig in die Hohlfaser (3) zu verhindern, und
**dass** etwa dort, wo die Hohlfaser (3) aus dem Kanal (2) nach außen austritt, im Kanal (2) jedenfalls die Wandabschnitte mit einer den Kanal (2) verbreiternden, vorzugsweise stufenartigen oder schräg verlaufenden, äußeren Kapillarstoppstruktur (9) ausgeführt sind.

9. Mikrofluidisches System nach Anspruch 8, **dadurch gekennzeichnet, dass** die äußere Kapillarstoppstruktur (9) am äußeren Ende des Kanals (2) eine trapezartige Erweiterung bildet.

10. Mikrofluidisches System nach Anspruch 8 oder 9, **dadurch gekennzeichnet, dass** die Kapillarstoppstruktur (9) durch den Kanal (2) vorzugsweise stufenartig verbreiternde Wandabschnitte und/oder einen insbesondere stirnseitigen Absatz der Hohlfaserwandung gebildet ist.

11. Mikrofluidisches System nach einem der Ansprüche 8 bis 10, **dadurch gekennzeichnet, dass** die Kapillarstoppstruktur (9) am inneren Ende eine beidseitige Stufe bildet.

12. Mikrofluidisches System nach einem der Ansprüche 8 bis 11, **dadurch gekennzeichnet, dass** mindestens ein dort, wo die Hohlfaser (3) eingelegt ist, seitlich in den Kanal (2) mündender Zulaufkanal (7) vorgesehen ist, dessen anderes Ende eine Eintrittsstelle für den im Verarbeitungszustand flüssigen Kleber (6) bildet.

13. Mikrofluidisches System nach einem der Ansprüche 8 bis 12, **dadurch gekennzeichnet, dass** mindestens ein dort, wo die Hohlfaser (3) eingelegt ist, seitlich vom Kanal (2) abgehender Ablaufkanal (8) vorgesehen ist, durch den überschüssiger Kleber (6) ablaufen kann.

14. Mikrofluidisches System nach einem der Ansprüche 8 bis 13, **dadurch gekennzeichnet, dass** die Abdeckfolie oder -platte (5) aus einem für Ultraviolett-Strahlung durchlässigen Material besteht, wobei die Abdeckfolie (5) eine Heißsiegelfolie ist.

15. Mikrofluidisches System nach einem der Ansprüche 8 bis 14, **dadurch gekennzeichnet, dass** mehreren Kanäle (2) des Netzwerks, in die Hohlfasern (3) eingelegt sind, durch mindestens einen Verbindungskanal (10) für den Kleber (6) miteinander verbunden sind, der die Funktion des Ablaufkanals für einen Kanal (2) und die Funktion des Zulaufkanals für den anderen Kanal (2) erfüllt.
